(19) Europäisches Patentamt
European Patent Office
Office européen des brevets

(11) Numéro de publication: **0 222 438 B1**

(12) # FASCICULE DE BREVET EUROPEEN

(45) Date de publication de fascicule du brevet: **08.05.91**

(51) Int. Cl.[5]: **C30B 19/10**, C30B 19/06, C30B 29/48

(21) Numéro de dépôt: **86201820.7**

(22) Date de dépôt: **20.10.86**

(54) **Creuset pour l'épitaxie en phase liquide de couches semiconductrices de composition contrôlée.**

(30) Priorité: **22.10.85 FR 8515655**

(43) Date de publication de la demande: **20.05.87 Bulletin 87/21**

(45) Mention de la délivrance du brevet: **08.05.91 Bulletin 91/19**

(84) Etats contractants désignés: **DE FR GB IT NL**

(56) Documents cités:
**GB-A- 2 081 010**
**GB-A- 2 132 228**

**PATENTS ABSTRACTS OF JAPAN, vol. 5, no. 86 (E-60)[758], 5 juin 1981; & JP-A-56 32 720 (HANDOUTAI KENKIYUU SHINKOUKAI) 02-04-1981**

(73) Titulaire: **LABORATOIRES D'ELECTRONIQUE PHILIPS**
**3, Avenue Descartes**
**F-94450 Limeil-Brévannes(FR)FR**

Titulaire: **N.V. Philips' Gloeilampenfabrieken**
**Groenewoudseweg 1**
**NL-5621 BA Eindhoven(NL)DE GB IT NL**

(72) Inventeur: **Latorre, Bernard Société Civile S.P.I.D.**
**209, rue de l'Université**
**F-75007 Paris(FR)**
Inventeur: **Montero, Manuel Société Civile S.P.I.D.**
**209, rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

EP 0 222 438 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

L'invention concerne un creuset pour la croissance de couches épitaxiales, de composés chimiques formés de plusieurs éléments chimiques, dont un au moins est volatil, par la méthode d'épitaxie en phase liquide, comprenant une embase allongée sur laquelle une partie mobile glisse longitudinalement, l'embase comprenant au moins un logement pour y placer un substrat sur lequel se dépose au moins une couche épitaxiale, la partie mobile comprenant au moins une cavité, recevant une source mère formée de matériaux initiaux d'épitaxie, la cavité présentant, sur la face qui jouxte l'embase, une ouverture inférieure dont les dimensions sont en rapport avec les dimensions des substrats qui y sont présentés, et au moins un réceptacle renfermant une source pour chaque élément volatil du composé chimique, le creuset étant destiné à être disposé dans un réacteur porté à une température d'épitaxie.

Une invention de ce genre est connue du brevet US 4 366 771.

Il est connu d'après ce document de réaliser des couches de $Hg_{1-x} Cd_x$ Te dans un creuset de graphite constitué de deux blocs dont un premier bloc est traversé par des cavités pouvant recevoir différentes compositions de sources, ce premier bloc étant mobile par rapport à un second bloc recevant le substrat. L'ensemble du creuset est placé dans un four tubulaire où circule un flux d'hydrogène.

Le second bloc reçoit le substrat dans un logement qui y est ménagé de telle sorte que le substrat affleure du second bloc. Les épaisseurs des substrats utilisés successivement doivent dont être calibrées en fonction de la profondeur donnée à ce logement.

L'épitaxie est effectuée typiquement à une température de 450°C à 500°C pour des solutions mères riches en tellure. Lorsque le temps nécessaire est écoulé, le substrat avec sa couche épitaxiale est séparé de la solution liquide par un mouvement de translation. La construction du creuset est telle que la couche épitaxiale est ainsi "essuyée" laissant l'état de surface plus ou moins correct selon la construction du creuset et la nature des constituants de la couche. L'épaisseur des couches est tributaire du jeu qui existe entre le niveau supérieur du substrat et le bloc mobile contenant les solutions mères.

Mais dans le cas de la croissance de couches épitaxiales de $Hg_{1-x} Cd_x$ Te des difficultés apparaissent à cause de la forte pression partielle du mercure comparée à celle du cadmium et du tellure. La source mère a tendance à s'appauvrir en mercure et une composition constante des couches épitaxiales n'est plus correctement assurée.

Afin de remédier à ce problème, le document US 4 366 771 décrit un creuset dans lequel les cavités de croissance communiquent avec une source de mercure. Ces cavités traversent le premier bloc mobile et sont entourées sur les deux faces de petites rainures peu profondes réunies entre elles sur les faces respectivement supérieure et inférieure par un prolongement des rainures et entre les deux faces par un trou pratiqué dans le premier bloc mobile, trou situé à l'écart des cavités. En fonctionnement, un bouchon est placé à la partie supérieure de la cavité pour en obstruer l'ouverture. L'apport de Hg s'effectue donc principalement de la partie supérieure vers la partie inférieure du premier bloc à travers ledit trou de sorte que l'apport supplémentaire de vapeurs de mercure s'effectue au niveau de la couche épitaxiale afin de rendre minimale la perte de mercure.

Après la réalisation de la première couche le substrat peut ensuite être mis en contact avec une seconde source pour obtenir une seconde couche de propriétés diffférentes.

Mais il n'est pas possible selon cette technique de contrôler correctement l'espace entre la couche terminée et le bloc supérieur, lié à l'épaisseur de la couche, ce qui est un paramètre déterminant pour l'essuyage, ni de s'affranchir des tolérances variables sur les épaisseurs des substrats, à plus fortes raison sur les substrats munis déjà de une ou plusieurs couches épitaxiales. Des dépôts multicouches sont donc très difficiles à contrôler et on est vite limité pour effectuer correctement la translation du bloc mobile.

D'autre part, la construction de ce creuset ne permet pas de contrôler d'une façon efficace et reproductible la composition chimique des couches et en particulier la teneur en mercure. Malgré la pression de mercure dans les rainures, pouvant différer légèrement de celle existant au dessus de la solution, le léger espace qui existe entre le premier et le deuxième bloc détermine le flux de mercure échangé entre la source de mercure et la solution. Ce léger espace ne peut être contrôlé d'une opération à une autre.

Un but de l'invention est donc de contrôler la composition des couches épitaxiales en contrôlant la composition de la source mère.

Un autre but est d'assurer l'homogénéité de cette composition pour toute l'épaisseur et pour toute la surface utile de la couche épitaxiale.

Pour cela, l'invention telle que définie dans le préambule est remarquable en ce que une au moins des cavités de la partie mobile, pour laquelle un substrat est présent devant l'ouverture inférieure, présente au moins une ouverture supérieure formée uniquement par un conduit calibré, relié chacun au réceptacle qui renferme une source de chaque élément volatil, chaque conduit étant calibré afin que l'apport de l'élément le plus volatil qu'il fournit à la solution mère, compense le perte de ce même élément due aux fuites existant au niveau de la couche épitaxiale.

Elle est également remarquable en ce que cet apport s'opère sur la surface de la source mère qui n'est pas en contact avec la couche épitaxiale.

Elle est également remarquable en ce que le conduit calibré contrôle l'apport dudit élément à la source mère, afin de compenser sensiblement les pertes dudit élément qui apparaissent au niveau de la couche, afin de conserver à la source mère une composition constante.

Le creuset selon l'invention est réalisé préférentiellement en graphite, mais il peut également être réalisé en nitrure de bore, ou en associant le graphite et le quartz. L'élévateur coulisse à frottements doux dans le logement de l'embase. Le substrat, placé sur l'élévateur, vient appuyer sur les deux lèvres de la rainure longitudinale pratiquée dans la partie mobile. Cette rainure a typiquement une profondeur de 30 $\mu$m. Les produits initiaux, tels que Cd, Te et Hg pour la croissance de couches de $Hg_{1-x}$ $Cd_x$ Te sont placés dans une cavité de la partie mobile. Après que le creuset ainsi chargé a été placé dans un four tubulaire en quartz où circule un gaz réducteur tel que l'hydrogène, les produits deviennent liquides à la température d'épitaxie qui est pour ces matériaux de 450 °C à 500 °C.

Le substrat est maintenu en contact avec les produits initiaux liquides pendant la durée nécessaire au dépôt de l'épaisseur de la couche épitaxiale recherchée par exemple 1/2 heure pour 30$\mu$m. A l'issue de cette durée la partie mobile est déplacée longitudinalement sur l'embase selon la direction de la rainure et l'épitaxie est alors terminée. Lors de cette opération seuls les bords du substrat en contact avec les lèvres de la rainure vont présenter de légères rayures alors que la majeure partie centrale de la couche épitaxiale présente une qualité de surface excellente.

Le substrat, ou lors d'opérations suivantes, la dernière couche épitaxiale, est donc toujours en appui sur les lèvres de la rainure, ce qui permet le contrôle du jeu mécanique et donc de la qualité des couches, quelle que soit l'épaisseur des substrats utilisés.

Cette force d'appui est développée par un système de pression constitué par un fléau. Celui-ci présente une structure dissymètrique de sorte que par rapport à un axe le traversant, une de ses extrémités va subir l'effet des forces de pesanteur et donc relever l'autre extrémité qui développe ainsi la force d'appui nécessaire.Ce système de pression est réalisé en totalité dans le même matériau que le creuset par exemple en graphite afin de n'apporter aucune pollution et une tenue excellente aux hautes températures.

Dans la croissance de couche épitaxiale en phase liquide, les éléments constitutifs du matériau formant la couche épitaxiale présentent des pressions de vapeurs propres, qui dans la plupart des cas sont très différentes. Ainsi, dans le cas de couches de $Hg_{1-x}$ $Cd_x$ Te, les pressions partielles propres de chaque élément constitutifs sont pour x = 0,3 :

pour

Cd ≃ $10^{-1}$ Pa à 500 °C
Te ≃ 100 Pa à 500 °C
Hg ≃ $10^4$ Pa à 500 °C

Ceci a pour conséquence que la source liquide va présenter une concentration qui va évoluer dans le temps.

La couche épitaxiale qui se forme à partir d'une telle source à concentration non stabilisée va elle-même présenter une composition qui va évoluer selon son épaisseur. Ceci est préjudiciable à la réalisation de dispositifs semiconducteurs aux propriétés bien définies, stables et reproductibles.

Pour surmonter cette difficulté le creuset comporte une partie mobile dont les cavités sont munies, à leur partie supérieure, d'un réservoir annulaire, destiné à recevoir une composition de l'élément dont la solution liquide mère à tendance à s'appauvrir. Les vapeurs dégagées par ce réservoir annulaire sont en contact avec la solution liquide contenue dans la cavité par l'intermédiaire d'au moins un conduit étroit qui permet de compenser l'appauvrissement de la solution liquide mère par les vapeurs issues du réservoir annulaire.

Le calibrage du conduit est déterminé afin que l'apport de l'élément le plus volatil qu'il fournit compense la perte de ce même élément dans la solution mère, perte qui s'effectue par les fuites existant au niveau de la couche épitaxiale.

Les couches de $Hg_{1-x}$ $Cd_x$ Te sont utilisées pour réaliser des détecteurs infra-rouge opérant dans la gamme de longueurs d'onnde de 3 à 5 $\mu$m ou de 8 à 12 $\mu$m.

L'invention sera mieux comprise à l'aide des dessins suivants, données à titre d'exemples non limitatifs, qui représentent :

- figure 1 : une vue en coupe d'un creuset selon l'invention avec un élévateur actionné par un fléau,
- figure 2 : une vue en coupe du creuset selon l'invention,
- figure 3 : une vue de dessous de la partie mobile du creuset.

Sur la figure 1 est représenté un four à épitaxie 70, généralement constitué d'un tube de quartz entouré d'en roulements chauffants non représentés. A l'intérieur de ce four est placé en creuset 71 selon l'invention. Il est constitué d'une embase 72, d'une partie mobile 73 et d'un couvercle 74. Ces

trois éléments coulissent les uns sur les autres à frottements doux selon la direction XX' qui est l'axe du tube du four d'épitaxie. Ils sont pour cela munis de gorges latérales.

Le calibrage du conduit est déterminé afin que l'apport de l'élément le plus volatil qu'il fournit compense la perte de ce même élément dans la solution mère, perte qui s'effectue par les fuites existant au niveau de la couche épitaxiale. Ainsi l'élévateur 75 peut se déplacer dans une direction sensiblement perpendiculaire à l'embase 72 à l'aide d'une force développée par un système de pression détaillé ci-après. L'élévateur 75 porte un substrat 76, représenté à une échelle plus grande pour la commodité du dessin.

La partie mobile 73 présente une cavité 77, ouverte dans la direction de l'embase 72, mais fermée dans sa partie supérieure à l'exception d'un conduit calibré 78 qui la réunit à un réceptacle préférentiellement annulaire 80 destiné à recevoir des matériaux de croissance à forte tension de vapeurs. La cavité 77 reçoit la solution riche en Te préalablement préparée pour la croissance de couche $Hg_{1-x}$ $Cd_x$ Te. A la température d'épitaxie ces matériaux constituent une source mère liquide 79. Le substrat 76 présente une dimension légèrement supérieure à l'ouverture de la cavité 77 afin que celui-ci ne puisse y pénétrer.

La figure 2 représente une vue en coupe, selon une direction perpendiculaire à la direction XX'. La partie mobile 73 présente sur toute sa longueur et selon XX' une rainure 81 de très faible profondeur. Ainsi le substrat ne peut être en contact avec la partie mobile 73 que par les deux lèvres latérales 82 de la rainure. En effet, lorsque la partie mobile 73 est posée sur l'embase 72 elle ne peut porter que sur les deux lèvres latérales 82 car un jeu 85 existe entre l'embase 72 et la partie mobile 73.

Sur la figure 3 est représentée une vue de dessous de la partie mobile 73. La rainure 81 est légèrement plus petite que la cavité 77 de sorte que les lèvres latérales 82 de la rainure 81 n'existent pas dans la cavité 77. Ainsi lorsque la partie mobile 73 est translatée sur l'embase 72 selon la direction XX', seules les surfaces du substrat 76 qui sont en contact avec les lèvres 82 vont présenter de petites rayures. Ces surfaces sont représentées sur la figure 3 par un pointillé. La majeure partie centrale du substrat 16 reste ainsi intacte.

La profondeur de la rainure 81 est déterminée en premier lieu par la fluidité de la solution mère aux températures d'épitaxie utilisées. En effet, il ne faut pas que par capillarité cette solution mère puisse passer entre l'embase 72 et la partie mobile 73. La rainure doit donc être aussi petite que possible. Une seconde limitation est déterminée parla qualité de l'état de surface du substrat. Un état de surface acceptable est par exemple de ne pouvoir voir qu'une ou deux franges d'interférence pour un substrat de 15 mm de diamètre. Ceci est caractéristique à la fois de l'état de surface et de la planéité du substrat. Pour conserver aux couches réalisées une très bonne qualité de surface, une rainure avec une profondeur de 30 $\mu$m a donné satisfaction.

Les tolérances très serrées données au jeu existant entre la partie mobile 73 et l'embase 72, associées à une rainure longitudinale de profondeur constante, font que même si l'embase 72 présente plusieurs postes analogues pour recevoir plusieurs substrats, la qualité de l'état de surface de toutes les couches est assurée.

La figure 1 représente un creuset selon l'invention pour lequel la force de pression est développée par un fléau 90. Ce fléau est excentré par rapport à un axe 91 de sorte que la partie 92 qui est en contact avec l'élévateur subit une force ascendante. Ceci est assurée en donnant à la partie 93 du fléau une masse supérieure à la partie 92 par exemple en intervenant sur sa forme. Ainsi l'élévateur 75 est sollicité vers le haut et plaque le substrat 76 sur les lèvres de la rainure de la partie mobile 73.

Dans le cas d'un creuset présentant plusieurs porte-substrats un fléau unique peut actionner simultanément tous les postes à l'aide d'un système de palonnier qui répartit de façon égale la force globale de pression produite par le fléau.

Du fait que l'élévateur 75 coulisse librement dans l'embase 72, il est possible d'utiliser des substrats 76 ayant des tolérances d'épaisseurs bien moins sévères que selon les arts antérieurs. De même, lorsque l'on désire réaliser des multicouches, les épaisseurs cumulées des couches ne perturbent pas la réalisation des couches suivantes.

Le processus de mise en oeuvre du creuset mobile est le suivant. Les proportions des produits de base Cd, Te et Hg de la solution mère sont déterminées afin d'obtenir la composition $Hg_{1-x}$ $Cd_x$ Te recherchée selon la valeur donnée à x à une température d'équilibre donnée. Dans l'exemple cité, les masses de la solution mère sont telles que la hauteur du bain liquide est de 3 mm environ. Dans ce cas, le régime hydrodynamique de la solution est stable, technique des petits bains. Cette solution est placée sur l'embase 72 et recouvertes de la partie mobile 73 de sorte qu'elles pénètrent dans la cavité 77. Durant cette opération la cavité 77 se trouve à l'écart du substrat 76 qui est positionné sur l'élévateur 76. Si l'on désire contrôler l'apport d'un ou plusieurs éléments volatils, le mercure dans le cas de $Hg_{1-x}$ $Cd_x$ Te, on place également une source de compensation, dans ce cas Hg Te, dans les réceptacles 80. Cet apport est nécessaire lorsque l'on désire contrôller finement

la composition chimique de la couche de $Hg_{1-x} Cd_x Te$. Le creuset est ensuite placé dans un four d'épitaxie vers 450 °C-500 °C dans un flux d'hydrogène. Lorsque le creuset atteint la température désirée, la partie mobile 73, qui contient alors les produits de base Cd, Te et Hg sous la forme d'une source mère à l'état liquide, est déplacée longitudinalement sur l'embase 72 de sorte que la source mère 79 se trouve en contact avec le substrat 76 et la croissance de la couche épitaxiale peut commercer. A la fin de l'épitaxie l'opération inverse est effectuée.La partie mobile 73 est glissée sur l'embase 72 puis l'ensemble du creuset 71 est retiré du four. La rainure placée dans la partie mobile 73 assure ainsi un parfait essuyage de la surface de la couche épitaxiale. Seules sont légèrement perturbées, et donc habituellement inutilisables, les deux parties latérales sur lesquelles portent les lèvres des rainures.La partie centrale utilisable peut alors être découpée pour former des dispositifs semiconducteurs destinés à la détection infrarouge.

Si l'on désire faire croître d'autres couches de composition différente, il est possible de placer le substrat avec sa première couche épitaxiale sur l'élévateur et d'opérer comme préalablement, les épaisseurs cumulées ne constituant pas un handicap pour ces nouvelles étapes.

Entre la partie mobile 73 et l'embase 72 il existe des fuites de matériaux de la source mère qui sont entrainés par le gaz vecteur utilisé, dans le cas présent de l'hydrogène. Cette perte de matériau appauvrit la source mère et la composition de la couche épitaxiale ne peut ainsi être assurée pour la totalité de l'épaisseur et de la surface de cette couche.

L'invention opère donc un apport de cet élément volatil à travers le conduit calibré. Pour cela il est indispensable de déterminer le taux de fuites qui existe au niveau de la couche épitaxiale. Le calibrage du conduit s'effectue donc en deux étapes. Une première étape consiste à déterminer la valeur de cette fuite qui dépend des caractéristiques du creuset d'épitaxie en particulier de l'existence ou de la non-existence d'une rainure telle que cela a été indiqué précédemment, ainsi que du jeu qui existe entre la partie mobile 73 et l'embase 72.

Le conduit calibré ne présente pas la même pression partielle à ses deux extrémités. Du côté du réceptacle la pression est $P_1$ du coté de la source mère la pression est $P_2$. Ces deux valeurs, malgré une évolution des concentrations en fonction du temps, restent sensiblement constantes.

A cette différence de pression correspond, dans le conduit calibré un flux $F_1$ de vapeurs, soit $P_1-P_2 = Z.F_1$, en appelant Z l'impédance du conduit calibré. Or, il est connu de l'homme de métier de la mécanique des fluides, que l'impédance d'un tel conduit est en première approximation égale à $Z = C/d^4$ où C est une constante (pour une longueur donnée) et d est le diamètre du tube. On constate que cette impédance varie très rapidement avec le diamètre ce qui explique qu'une précision très grande peut être atteinte. Donc : $P_1-P_2 = C(F_1/d^4)$.

Le flux $F_1$ est directement lié à la variation dans le temps de concentration D de la source mère, plus le flux qui s'échappe à travers les fuites au niveau de la couche, soit $F_1 = D+f$.

A l'aide d'une mesure préalable il est ainsi possible de déterminer la valeur de f qui dépend des caractéristiques de construction du montage, puis de contrôler le flux $F_1$, à l'aide du conduit calibré, pour obtenir une compensation sensiblement exacte du flux f, ce qui revient à obtenir une variation de concentration D sensiblement nulle.

La première opération consiste à déterminer les proportions de matériaux de base formant la source mère afin d'obtenir la couche épitaxiale de $Hg_{1-x} Cd_x Te$ avec la valeur x recherchée, sur la base de la composition obtenu en tube fermée, tel que cela est connu de l'Homme du métier, soit par exemple $x = 0,30$ la valeur recherchée. Les quantités nécessaires de Cd, Te et Hg sont alors mélangées. On choisit un calibre de trou en fonction des dimensions de la cavité 77 de la partie mobile 73. Pour une cavité de 16 mm de diamètre et 10 mm de haut, on choisit, par exemple, un conduit formé d'un trou de 0,250 mm de diamètre et 3 mm de hauteur. On place une certaine quantité P de Hg Te dans le réceptacle 80 qui constitue dans le cas présent la source de mercure. Selon la procédure d'épitaxie déjà décrite, on fait croître la couche épitaxiale de faible épaisseur (≃ 10 µm), afin d'avoir une composition sensiblement homogène. La couche obtenue présente donc une certaine composition x' différente de la composition x recherchée. Cette composition x' est déterminée à l'aide de courbes de transmission optique, en fonction de la composition des couches, connues de l'Homme du métier ou directement par sonde à rayons X.

Avec les caractéristiques de creuset décrites ci-dessus on a obtenu une couche avec une composition $x' = 0,44$. L'écart entre les deux valeurs est : $x'-x = 0,14$.

D'après le diagramme ternaire, connu de l'Homme du métier, la variation dx pour les compositions x et x' en cause est reliée à la variation de teneur en mercure par $dX_{Hg} \simeq -0,2.dx$, pour $X_{Hg} \simeq 10\%$.

Ceci permet de déterminer la variation de composition de la source mère. Dans le cas précité, la solution mère étant de 2,5 g, on obtient, après quelques équations simples, que la source mère a subi sensiblement une perte de 0,10 g de mercure,

ce qui permet de déterminer l'importance de la fuite au niveau de la couche épitaxiale. Cette perte se produit pendant le temps de montée en température, d'homogénéisation et de croissance.

Pour deux conduits calibrés de dimensions voisines la variation de pression $P_1$-$P_2$ est sensiblement la même, soit :

$$\frac{F_1}{d_1^4} = \frac{F_2}{d_2^4}$$

avec $F_1 = D_1 + f$,

et $F_2 = f$ puisque $D_2 = 0$

on a : $$\frac{D_1+f}{d_1^4} = \frac{f_2}{d_2^4}.$$

La fuite est déterminée à partir de la perte de poids de Hg Te dans le réceptacle qui donne le flux $F_1$ et à partir de la variation de concentration de la source mère qui donne $D_1$ pour un diamètre $d_1$ de conduit calibré. On obtient ainsi aisément le diamètre $d_2$ qui donne une variation de concentration $D_2 = 0$ dans le second cas.

Dans l'exemple précité, un diamètre $d_2$ = 0,350 mm a donné satisfaction pour obtenir des couches avec x = 0.30. Pour obtenir d'autres compositions, et pour un tel creuset, le diamètre du conduit calibré se situe sensiblement dans la gamme 0,1 mm à 0,5 mm.

Si le premier trou est mal choisi, ce qui a pour conséquence de conduire à une valeur de dx relativement grande par rapport à x, il peut s'avérer nécessaire d'effecuter une seconde opération afin d'obtenir un calibre de trou approprié.

L'exemple qui vient d'être traité concerne des couches de $Hg_{1-x}$ $Cd_x$ Te, mais l'invention peut concerner également d'autres compositions semiconductrices. Il peut alors apparaître que plusieurs éléments présentent des pressions partielles élevées. Dans ce cas le creuset comporte plusieurs réceptacles séparés, chacun étant relié à la solution mère par un conduit calibré approprié défini par l'invention.

## Revendications

1. Creuset pour la croissance de couches épitaxiales, de composés chimiques formés de plusieurs éléments chimiques, dont un au moins est volatil, par la méthode d'épitaxie en phase liquide, comprenant une embase allongée sur laquelle une partie mobile glisse longitudinalement, l'embase comprenant au moins un logement pour y placer un substrat sur lequel se dépose au moins une couche épitaxiale, la partie mobile comprenant au moins une cavité, recevant une source mère formée de matériaux initiaux d'épitaxie, la cavité présentant, sur la face qui jouxte l'embase, une ouverture inférieure dont les dimensions sont en rapport avec les dimensions des substrats qui y sont présentés, et au moins un réceptacle renfermant une source pour chaque élément volatil du composé chimique, le creuset étant destiné à être disposé dans un réacteur porté à une température d'épitaxie, caractérisé en ce que une au moins des cavités de la partie mobile, pour laquelle un substrat est présent devant l'ouverture inférieure, présente au moins une ouverture supérieure formée uniquement par un conduit calibré, relié chacun au réceptacle qui renferme une source de chaque élément volatil, chaque conduit étant calibré afin que l'apport de l'élément le plus volatil qu'il fournit à la solution mère, compense la perte de ce même élément due aux fuites existant au niveau de la couche épitaxiale.

2. Creuset selon la revendication 1, caractérisé en ce que le conduit calibré effectue l'apport de l'élément volatil par la surface de la source mère qui n'est pas en contact avec la couche épitaxiale.

3. Creuset selon la revendication 2, caractérisé en ce que le conduit calibré maintient une composition sensiblement constante à la source mère.

4. Creuset selon la revendication 3, caractérisé en ce que le réceptacle est constitué d'une gorge périphérique, entourant le conduit calibré, sa surface étant très supérieure à la section du conduit calibré.

5. Creuset selon une des revendications 1 à 4, caractérisé en ce que le conduit calibré est constitué d'un trou de diamètre compris entre 100 $\mu$m et 500 $\mu$m.

## Claims

1. A crucible for growing epitaxial layers of chemical compounds formed by several chemical elements, at least one of which is volatile, by the method of epitaxy from the liquid, comprising an elongate support, on which a movable part slides longitudinally, the support comprising at least one recess for accommodating a substrate on which at least

one epitaxial layer is deposited, the movable part comprising at least one cavity receiving a mother source formed from initial materials for epitaxy, the cavity having on the surface adjoining the support a lower opening, whose dimensions correspond to the dimensions of the substrates which are provided there, and at least one receptacle accommodating a source for each volatile element of the chemical compound, the crucible being intended to be arranged in a reactor brought to an epitaxy temperature, characterized in that at least one of the cavities of the movable part, for which a substrate is present in front of the lower opening, has at least one upper opening formed solely by a calibrated conduit, each such conduit being connected to the receptacle accommodating a source of each volatile element and each conduit being calibrated in such a way that the supply of the most volatile element which it furnishes to the mother solution compensates for the loss of this same element caused by leakage at the level of the epitaxial layer.

2. A crucible as claimed in Claim 1, characterized in that the calibrated conduit provides for the supply of the volatile element through the surface of the mother source which is not in contact with the epitaxial layer.

3. A crucible as claimed in Claim 2, characterized in that the calibrated conduit maintains a substantially constant composition for the mother source.

4. A crucible as claimed in Claim 3, characterized in that the receptacle is constituted by a peripheral recess surrounding the calibrated conduit, its surface being much larger than the section of the calibrated conduit.

5. A crucible as claimed in any one of Claims 1 to 4, characterized in that the calibrated conduit is constituted by a hole having a diameter lying between 100 $\mu$m and 500 $\mu$m.

## Ansprüche

1. Tiegel zum Wachsen von Epitaxialschichten mit chemischen Zusammensetzungen, die durch mehrere chemische Elemente gebildet sind, von denen wenigstens eine flüchtig ist, durch das Flüssigphasenepitaxieverfahren, mit einem länglichen Träger, auf dem ein beweglicher Teil in der längsrichtung sich verschiebt, wobei der Träger wenigstens eine Ausnehmung zum Aufnehmen eines Substrats aufweist, auf dem wenigstens eine Epitaxialschicht niedergeschlagen wird, wobei der bewegliche Teil wenigstens einen Hohlraum aufweist, der eine Mutterquelle erhält, die aus den Ausgangsmaterialien der Epitaxie gebildet ist, wobei der Hohlraum an der an den Träger grenzenden Fläche eine untere Öffnung aufweist, deren Abmessungen denen des darin befindlichen Substrats entsprechen, sowie wenigstens einen Behälter für eine Quelle jedes flüchtigen Elementes der chemischen Zusammensetzung, wobei der Tiegel in einem Reaktor angeordnet und auf eine Epitaxietemperatur gebracht werden soll, dadurch gekennzeichnet, daß wenigstens einer der Hohlräume des beweglichen Teils, für den vor der unteren Öffnung ein Substrat vorhanden ist, wenigstens eine obere Öffnung hat, die nur durch einen geeichten Kanal gebildet ist, wobei die Kanäle mit je einem Behälter für eine Quelle jedes flüchtigen Elementes verbunden ist, wobei jeder Kanal geeicht ist, damit die Zufuhr des flüchtigsten Elementes durch diesen Kanal den Verlust dieses Elementes durch Undichtigkeiten auf dem Pegel der Epitaxialschicht ausgleicht.

2. Tiegel nach Anspruch 1, dadurch gekennzeichnet, daß der geeichte Kanal die Zufuhr des flüchtigen Elementes durch diejenige Oberfläche der Mutterquelle versorgt, die nicht mit der Epitaxialschicht in Kontakt ist.

3. Tiegel nach Anspruch 2, dadurch gekennzeichnet, daß der geeichte Kanal eine nahezu konstante Zusammensetzung zu der Mutterquelle beibehält.

4. Tiegel nach Anspruch 3, dadurch gekennzeichnet, daß der Behälter durch eine umlaufende Ausnehmung gebildet ist, die den geeichten Kanal umgibt, wobei ihre Oberfläche viel größer ist als der Querschnitt des geeichten Kanals.

5. Tiegel nach einem der vorstehenden Ansprüche 1 bis 4, dadurch gekennzeichnet, daß der geeichte Kanal durch ein Loch mit einem Durchmesser zwischen 100 $\mu$m und 500 $\mu$m gebildet ist.

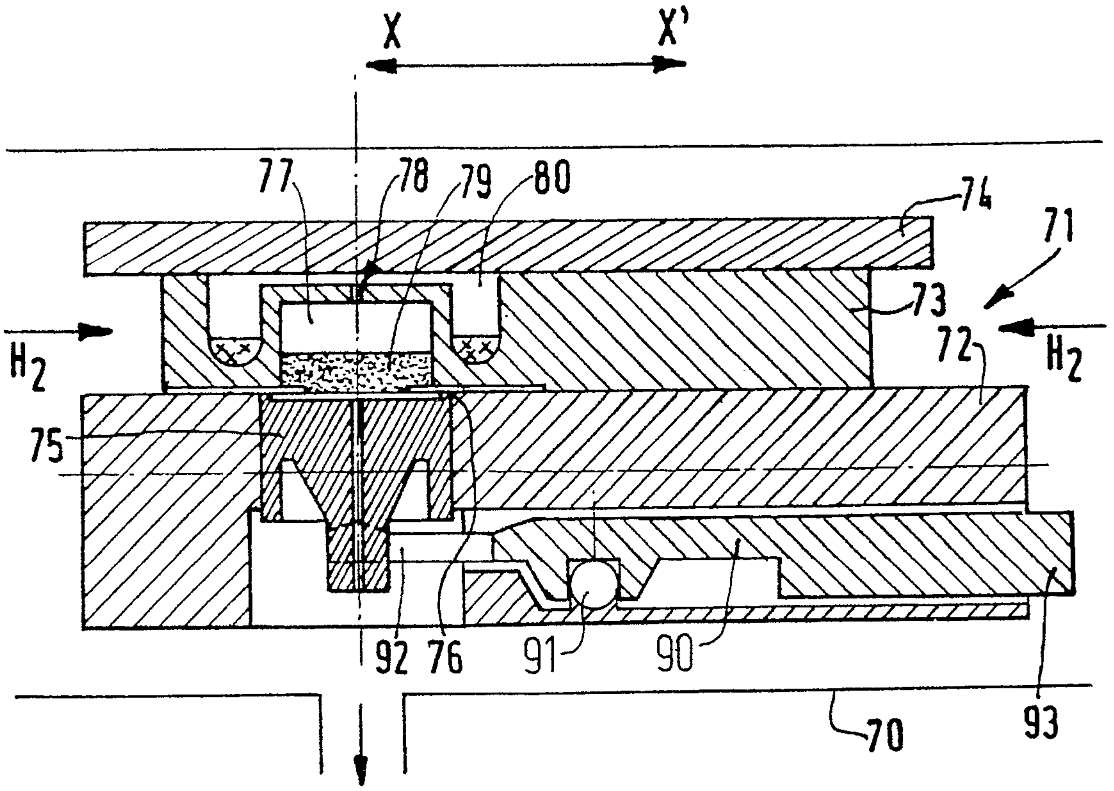


FIG.1

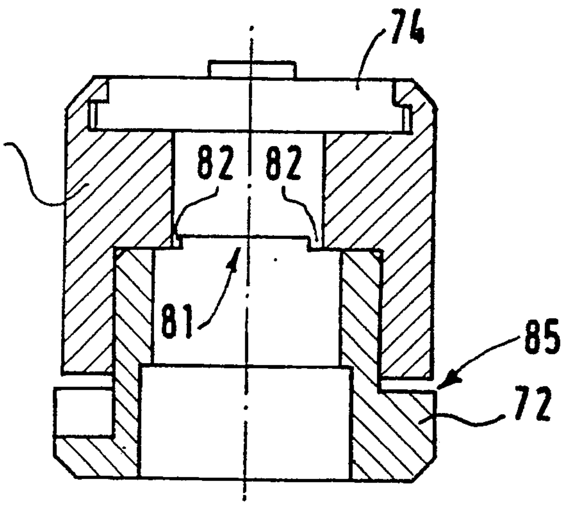


FIG.2

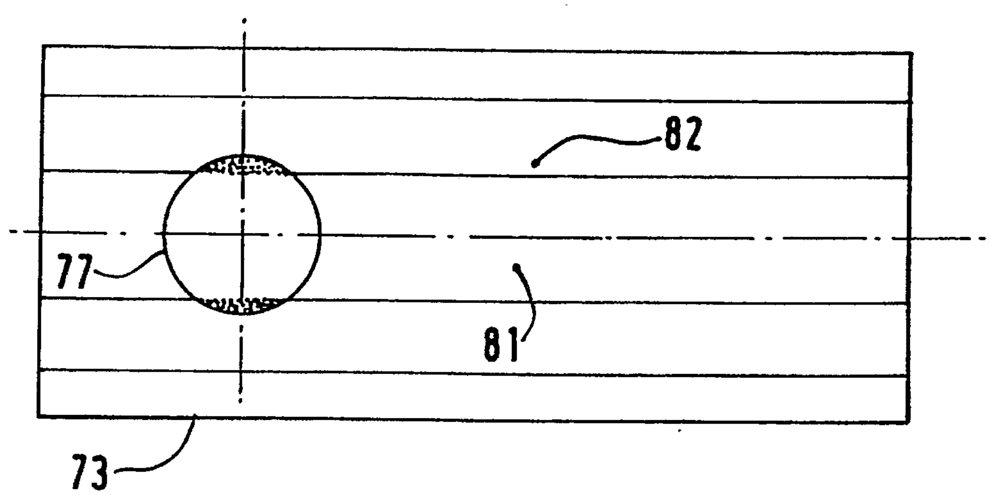


FIG.3